# EUROPÄISCHE PATENTSCHRIFT

(11) **EP 0 907 969 B1**
(45) Veröffentlichungstag und Bekanntmachung des Hinweises auf die Patenterteilung: **26.05.2004**
(21) Anmeldenummer: 97931666.8
(22) Anmeldetag: 26.06.1997
(51) Int. Cl.: H01L 33/00, H01S 5/32

(54) **LICHTABSTRAHLENDES HALBLEITERBAUELEMENT MIT LUMINESZENZKONVERSIONSELEMENT**
LIGHT-EMITTING SEMICONDUCTOR COMPONENT WITH LUMINESCENCE CONVERSION ELEMENT
COMPOSANT A SEMI-CONDUCTEUR LUMINESCENT AVEC ELEMENT DE CONVERSION DE LA LUMINESCENCE

(30) Priorität: 26.06.1996 DE 19625622; 20.09.1996 DE 19638667
(43) Veröffentlichungstag der Anmeldung: 14.04.1999
(73) Patentinhaber: Osram Opto Semiconductors GmbH, 93049 Regensburg (DE)
(72) Erfinder: REEH, Ulrike, D-80995 München (DE); HÖHN, Klaus, D-82024 Taufkirchen (DE); STATH, Norbert, D-93049 Regensburg (DE); WAITL, Günther, D-93049 Regensburg (DE); SCHLOTTER, Peter, D-79113 Freiburg (DE); SCHMIDT, Rolf, D-79279 Vörstetten (DE); SCHNEIDER, Jürgen, D-79199 Kirchzarten (DE)
(74) Vertreter: Epping, Hermann, Fischer
(86) Internationale Anmeldenummer: PCT/DE1997/001337
(87) Internationale Veröffentlichungsnummer: WO 1997/050132

(56) Entgegenhaltungen:
- DE-A- 3 315 675
- DE-U- 9 013 615
- PATENT ABSTRACTS OF JAPAN vol. 017, no. 542 (E-1441), 29.September 1993 & JP 05 152609 A (NICHIA CHEM IND LTD), 18.Juni 1993,
- PATENT ABSTRACTS OF JAPAN vol. 096, no. 005, 31.Mai 1996 & JP 08 007614 A (NICHIA CHEM IND LTD), 12.Januar 1996,

## Beschreibung

Die Erfindung bezieht sich auf ein lichtabstrahlendes Halbleiterbauelement mit Lumineszenzkonversionselement.

Ein derartiges Halbleiterbauelement ist beispielsweise aus der Offenlegungsschrift DE 38 04 293 bekannt. Darin ist eine Anordnung mit einer Elektrolumineszenz- oder Laserdiode beschrieben, bei der das gesamte von der Diode abgestrahlte Emmissionsspektrum mittels eines mit einem fluoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

Aus JP-A-5 152 609 ist ein Halbleiterbauelement bekannt, bei dem zur Verbesserung der Sichtbarkeit und Helligkeit ein Fluoreszenzfarbstoff oder Fluoreszenzpigment verwendet wird, das von dem Licht des Halbleiters angeregt wird und Fluoreszenzlicht emittiert.

Aus DE-OS 2 347 289 ist eine Infrarot(IR)-Festkörperlampe bekannt, bei der an der Kante einer IR-Diode Leuchtstoff-Material angebracht ist, das die dort abgestrahlte IR-Strahlung in sichtbares Licht umwandelt. Ziel dieser Maßnahme ist es, zu Kontrollzwecken einen möglichst geringen Teil der von der Diode abgegebenen IR-Strahlung bei gleichzeitig möglichst geringer Verminderung der Intensität der abgegebenen IR-Strahlung in sichtbares Licht umzuwandeln.

Weiterhin ist aus der EP 486 052 eine lichtemittierende Diode bekannt, bei der zwischen dem Substrat und einer aktiven elektrolumineszierenden Schicht mindestens eine Halbleiter-Photolumineszenzschicht angeordnet ist, die das von der aktiven Schicht in Richtung Substrat ausgesandte Licht eines ersten Wellenlängenbereichs in Licht eines zweiten Wellenlängenbereichs umwandelt, so daß die lichtemittierende Diode insgesamt Licht verschiedener Wellenlängenbereiche aussendet.

In DE-U-90 13 615 wird eine Elektrolumineszenz- oder Laserdiode mit einer Kunststoffmatrix beschrieben, die einen lichtwandelnden Farbstoff enthält. Dort werden verschiedene Farbstoffe, die organische Farbstoffe sein können, eingesetzt, die bezüglich ihres Verschiebungsbereichs nach Art einer Kaskade aufeinander abgestimmt sind.

In vielen potentiellen Anwendungsgebieten für Leuchtdioden, wie zum Beispiel bei Anzeigeelementen im Kfz-Armaturenbrett, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen läßt.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, daß die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, z. B. aufgrund von Unebenheiten der Oberfläche der transparenten Platte, eine Änderung des Weißtones des abgestrahlten Lichtes hervorruft.

In JP-A-8 007 614 wird ebenfalls eine planare weiße Lichtquelle beschrieben, in der mindestens eine Leuchtdiode blaues Licht in die Stirnseite einer Lichtleiterplatte ausstrahlt. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte und an der anderen, mit einer Streuschicht versehenen Hauptfläche gestreute blaue Licht.

Der vorliegenden Erfindung liegt die Aufgabe zugrunde, ein Halbleiterbauelement der eingangs genannten Art zu entwickeln, das homogenes mischfarbiges Licht abstrahlt und das eine technisch einfache Massenfertigung mit weitestgehend reproduzierbarer Bauelementcharakteristik gewährleistet.

Diese Aufgabe wird durch ein Halbleiterbauelement nach Anspruch 1 gelöst. Vorteilhafte Weiterbildungen der Erfindung sind Gegenstand der Unteransprüche 2 bis 25. Die Unteransprüche 26 bis 28 geben bevorzugte Verwendungsmöglichkeiten des erfingungsgemäßen Halbleiterbauelements an.

Es ist vorgesehen, daß der strahlungsemittierende Halbleiterkörper eine Schichtenfolge, insbesondere eine Schichtenfolge mit einer aktiven Halbleiterschicht aus GaₓIn₁₋ₓN oder GaₓAl₁₋ₓN aufweist, die im Betrieb des Halbleiterbauelements eine elektromagnetische Strahlung eines ersten Wellenlängenbereiches aus dem ultravioletten, blauen und/oder grünen Spektralbereich aussendet. Das Lumineszenzkonversionselement wandelt einen Teil der aus dem ersten Wellenlängenbereich stammenden Strahlung in Strahlung eines zweiten Wellenlängenbereiches um, derart, daß das Halbleiterbauelement Mischstrahlung, insbesondere mischfarbiges Licht, bestehend aus Strahlung des ersten Wellenlängenbereiches und Strahlung des zweiten Wellenlängenbereiches aussendet. Das heißt beispielsweise, daß das Lumineszenzkonversionselement einen Teil der vom Halbleiterkörper ausgesandten Strahlung bevorzugt nur über einen spektralen Teilbereich des ersten Wellenlängenbereichs spektral selektiv absorbiert und im längerwelligen Bereich (im zweiten Wellenlängenbereich) emittiert. Bevorzugt weist die von dem Halbleiterkörper ausgesandte Strahlung bei einer Wellenlänge λ ≤ 520 nm ein relatives Intensitätsmaximum auf und liegt der von dem Lumineszenzkonversionselement spektral selektiv absorbierte Wellenlängenbereich außerhalb dieses Intensitätsmaximums.

Ebenso kann vorteilhafterweise mit der Erfindung auch eine Anzahl (einer oder mehrere) von aus dem ersten Wellenlängenbereich stammenden ersten spektralen Teilbereichen in mehrere zweite Wellenlängenbereiche umgewandelt werden. Dadurch ist es vorteilhafterweise möglich, vielfältige Farbmischungen und Farbtemperaturen zu erzeugen.

Das erfindungsgemäße Halbleiterbauelement hat den besonderen Vorteil, daß das über Lumineszenkonversion erzeugte Wellenlängenspektrum und damit die Farbe des abgestrahlten Lichtes nicht von der Höhe der Betriebsstromstärke durch den Halbleiterkörper abhängt. Dies hat insbesondere dann große Bedeutung, wenn die Umgebungstemperatur des Halbleiterbauelementes und folglich bekanntermaßen auch die Betriebsstromstärke stark schwankt. Besonders Leuchtdioden mit einem Halbleiterkörper auf der Basis von GaN sind diesbezüglich sehr empfindlich.

Außerdem benötigt das erfindungsgemäße Halbleiterbauelement nur eine einzige Ansteuerspannung und damit auch nur eine einzige Ansteuerschaltungsanordnung, wodurch der Bauteileaufwand für die Ansteuerschaltung des Halbleiterbauelements sehr gering gehalten werden kann.

Als Lumineszenzkonversionselement ist über oder auf dem Halbleiterkörper eine teiltransparente, d. h. eine für die von dem Strahlung aussendenden Halbleiterkörper ausgesandte Strahlung teilweise transparente Lumineszenzkonversionsschicht vorgesehen. Um eine einheitliche Farbe des abstrahlten Lichtes sicherzustellen, ist vorteilhafterweise die Lumineszenzkonversionsschicht derart ausgebildet, daß sie durchweg eine konstante Dicke aufweist. Dies hat den besonderen Vorteil, daß die Weglänge des von dem Halbleiterkörper abgestrahlten Lichtes durch die Lumineszenzkonversionsschicht hindurch für alle Strahlungsrichtungen nahezu konstant ist. Dadurch kann erreicht werden, daß das Halbleiterbauelement in alle Richtungen Licht derselben Farbe abstrahlt. Ein weiterer besonderer Vorteil eines erfindungsgemäßen Halbleiterbauelements gemäß dieser Weiterbildung besteht darin, daß auf einfache Weise eine hohe Reproduzierbarkeit erzielt werden kann, was für eine effiziente Massenfertigung von wesentlicher Bedeutung ist. Als Lumineszenzkonversionsschicht kann beispielsweise eine mit Leuchtstoff versetzte Lack- oder Harzschicht vorgesehen sein.

Bei weiteren vorteilhaften Ausführungsformen des erfindungsgemäßen Halbleiterbauelements und der oben genannten bevorzugten Ausführungsformen besteht die Lumineszenzkonversionsschicht aus einem transparenten Material, z. B. Kunststoff, bevorzugt Epoxidharz, das mit mindestens einem Leuchtstoff versehen ist (Beispiele für bevorzugte Kunststoffe und Leuchtstoffe finden sich weiter unten). Auf diese Weise lassen sich Lumineszenzkonversionselemente besonders kostengünstig herstellen. Die dazu notwendigen Verfahrensschritte sind nämlich ohne großen Aufwand in herkömmliche Produktionslinien für Leuchtdioden integrierbar.

Bei einer besonders bevorzugten Weiterbildung der Erfindung bzw. der o. g. Ausführungsformen ist vorgesehen, daß der oder die zweiten Wellenlängenbereiche im Wesentlichen größere Wellenlängen aufweisen als der erste Wellenlängenbereich.

Insbesondere ist vorgesehen, daß ein zweiter spektraler Teilbereich des ersten Wellenlängenbereiches und ein zweiter Wellenlängenbereich zueinander komplementär sind. Auf diese Weise kann aus einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung aus dem blauen Spektralbereich in den zu Blau komplementärfarbigen gelben Spektralbereich konvertiert. Die Farbtemperatur-oder Farbort des weißen Lichtes kann dabei durch geeignete Wahl des Lumineszenzkonversionselementes, insbesondere durch eine geeignete Wahl des Leuchtstoffes, dessen Partikelgröße und dessen Konzentration, variiert werden. Darüberhinaus bieten diese Anordnungen vorteilhafterweise auch die Möglichkeit, Leuchtstoffmischungen einzusetzen, wodurch sich vorteilhafterweise der gewünschte Farbton sehr genau einstellen läßt. Ebenso können Lumineszenzkonversionselemente inhomogen ausgestaltet sein, z. B. mittels einer inhomogenen Leuchtstoffverteilung. Unterschiedliche Weglängen des Lichtes durch das Lumineszenzkonversionselement können dadurch vorteilhafterweise kompensiert werden.

Bei einer weiteren bevorzugten Ausführungsform des erfindungsgemäßen Halbleiterbauelements weist das Lumineszenzkonversionselement oder ein anderer Bestandteil einer Bauteilumhüllung zur Farbanpassung einen oder mehrere Farbstoffe auf, die keine Wellenlängenkonversion bewirken. Hierzu können die für die Herstellung von herkömmlichen Leuchdioden verwendeten Farbstoffe wie z. B. Azo-, Anthrachinon- oder Perinon-Farbstoffe eingesetzt werden.

Zum Schutz des Lumineszenzkonversionselements vor einer zu hohen Strahlenbelastung ist bei einer vorteilhaften Weiterbildung bzw. bei den o. g. bevorzugten Ausführungsformen des erfindungsgemäßen Halbleiterbauelements zumindest ein Teil der Oberfläche des Halbleiterkörpers von einer ersten, z. B. aus einem Kunststoff bestehenden transparenten Hülle umgeben, auf der die Lumineszenzkonversionsschicht aufgebracht ist. Dadurch wird die Strahlungsdichte im Lumineszenzkonversionselement und somit dessen Strahlungsbelastung verringert, was sich je nach verwendeten Materialien positiv auf die Lebensdauer des Lumineszenzkonversionselementes auswirkt.

Bei einer besonders bevorzugten Ausgestaltung der Erfindung sowie der oben genannten Ausführungsformen ist ein strahlungsemittierender Halbleiterkörper verwendet, bei dem das ausgesandte Strahlungsspektrum bei einer Wellenlänge zwischen 420nm und 460 nm, insbesondere bei 430 nm (z. B. Halbleiterkörper auf der Basis von GaₓAl₁₋ₓN) oder 450 nm (z. B. Halbleiterkörper auf der Basis von GaₓIn₁₋ₓN) ein Intensitätsmaximum aufweist. Mit einem derartigen erfindungsgemäßen Halbleiterbauelement lassen sich vorteilhafterweise nahezu sämtliche Farben und Mischfarben der C.I.E.-Farbtafel erzeugen. Der strahlungsemittierende Halbleiterkörper kann hierbei, wie oben angegeben, im Wesentlichen aus elektrolumineszierendem Halbleitermaterial aber auch aus einem anderen elektrolumineszierenden Material, wie beispielsweise Polymermaterial bestehen.

Bei einer weiteren besonders bevorzugten Weiterbildung der Erfindung und deren Ausführungsformen ist die Lumineszenzkonversionsschicht aus einem Lack oder aus einem Kunststoff hergestellt, beispielsweise aus einem für die Umhüllung optoelektronischer Bauelemente eingesetzten Silikon-, Thermoplast- oder Duroplastmaterial (Epoxid- u. Acrylatharze). Desweiteren können z. B. aus Thermoplastmaterialien gefertigte Abdeckelemente als Lumineszenzkonversionselement eingesetzt sein. Sämtliche oben genannten Materialien lassen sich auf einfache Weise mit einem oder mehreren Leuchtstoffen versetzen.

Besonders einfach läßt sich ein erfindungsgemäßes Halbleiterbauelement dann realisieren, wenn der Halbleiterkörper in einer Ausnehmung eines gegebenenfalls vorgefertigten Gehäuses angeordnet ist und die Ausnehmung mit einem die Lumineszenzkonversionsschicht aufweisenden Abdeckelement versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse das Abdeckelement, beispielsweise eine Lack- oder Gießharzschicht oder eine vorgefertigtes Abdeckplatte aus Thermoplastmaterial, auf das Gehäuse aufgebracht werden. Optional kann die Ausnehmung des Gehäuses mit einem transparenten Material, beispielsweise einem transparenten Kunststoff, gefüllt sein, das insbesondere die Wellenlänge des von dem Halbleiterkörper ausgesandten Lichtes nicht verändert oder aber, falls gewünscht, bereits lumineszenzkonvertierend ausgebildet sein kann.

Bei einer aufgrund besonders einfacher Realisierbarkeit besonders bevorzugten Weiterbildung des erfindungsgemäßen Halbleiterbauelements ist der Halbleiterkörper in einer Ausnehmung eines gegebenenfalls vorgefertigten eventuell bereits mit einem Leadframe versehenen Gehäuse angeordnet und ist die Ausnehmung mit einem zumindest teiltransparenten Gießharz gefüllt, dem der Leuchtstoff bereits vor dem Ausgießen der Ausnehmung zugefügt ist. Das Lumineszenzkonversionselement ist hier somit von dem mit Leuchtstoff versehenen Verguß des Halbleiterkörpers versehen.

Ein besonders bevorzugtes Material zur Herstellung des Lumineszenzkonversionselements ist Epoxidharz, dem ein oder mehrere Leuchtstoffe zugesetzt sind. Anstelle von Epoxidharz kann aber auch Polymethylmetacrylat (PMMA) verwendet sein.

PMMA läßt sich auf einfache Weise mit organischen Farbstoffmolekülen versetzen. Zur Herstellung von grün-, gelb- und rotleuchtenden erfindungsgemäßen Halbleiterbauelementen können z. B. Farbstoffmoleküle auf Perylen-Basis verwendet sein. Im UV, im Sichtbaren oder im Infraroten leuchtende Halbleiterbauelemente können auch durch Beimischung von 4f-metallorganischen Verbindungen hergestellt werden. Insbesondere können rotleuchtende erfindungsgemäße Halbleiterbauelemente z. B. durch Beimischung von auf Eu³⁺ basierenden metallorganischen Chelaten (λ ≈ 620 nm) realisiert werden. Infrarot strahlende erfindungsgemäße Halbleiterbauelemente, insbesondere mit blaues Licht aussendenden Halbleiterkörpern, können mittels Beimischung von 4f-Chelaten oder von Ti³⁺-dotiertem Saphir hergestellt werden.

Ein weißes Licht abstrahlendes erfindungsgemäßes Halbleiterbauelement läßt sich vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Geeignete organische Leuchtstoffe für ein weißes Licht abstrahlendes erfindungsgemäßes Halbleiterbauelement sind Perylen-Leuchtstoffe wie z. B. BASF Lumogen F 083 für grüne Lumineszenz, BASF Lumogen F 240 für gelbe Lumineszenz und BASF Lumogen F 300 für rote Lumineszenz. Diese Farbstoffe lassen sich auf einfache Weise z. B. transparentem Epoxidharz zusetzen.

Eine bevorzugte Methode, mit einem blaues Licht abstrahlenden Halbleiterkörper ein grün leuchtendes Halbleiterbauelement herzustellen, besteht darin, für das Lumineszenzkonversionselement UO₂⁺⁺-substituiertes Borsilikatglas zu verwenden.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements optimieren.

Bei einer besonders vorteilhaften Ausführungsform des erfindungsgemäßen Halbleiterbauelements besteht das Lumineszenzkonversionselement zumindest teilweise aus einem transparenten Epoxidharz, das mit einem anorganischen Leuchtstoff versehen ist. Vorteilhafterweise lassen sich nämlich anorganische Leuchtstoffe auf einfache Weise in Epoxidharz einbinden.Ein besonders bevorzugter anorganischer Leuchtstoff zur Herstellung von Weiß leuchtenden erfindungsgemäßen Halbleiterbauelementen ist der Phosphor YAG:Ce (Y₃Al₅O₁₂:Ce³⁺). Dieser läßt sich auf besonders einfache Weise in herkömmlich in der LED-Technik verwendeten transparenten Epoxidharzen mischen. Weiterhin als Leuchtstoffe denkbar sind weitere mit Seltenen Erden dotierte Granate wie z. B. Y₃Ga₅O₁₂:Ce³⁺, Y(Al,Ga)₅O₁₂:Ce³⁺ und Y(Al,Ga)₅O₁₂:Tb³⁺ sowie mit Seltenen Erden dotierte Erdalkali-Sulfide wie z. B. SrS:Ce³⁺,Na, SrS:Ce³⁺,Cl, SrS:CeCl₃, CaS:Ce³⁺ und SrSe:Ce³⁺.

Zur Erzeugung von verschiedenartig mischfarbigem Licht eignen sich darüberhinaus besonders die mit Seltenen Erden dotierten Thiogallate wie z. B. CaGa₂S₄:Ce ³⁺ und SrGa₂S₄:Ce³⁺. Ebenso ist hierzu die Verwendung von mit Seltenen Erden dotierten Aluminaten wie z. B. YAlO₃:Ce³⁺, YGaO₃:Ce³⁺, Y(Al,Ga)O₃:Ce³⁺ und mit Seltenen Erden dotierten Orthosilikaten M₂SiO₅:Ce³⁺ (M: Sc, Y, Sc) wie z. B. Y₂SiO₅:Ce³⁺ denkbar. Bei allen Yttriumverbindungen kann das Yttrium im Prinzip auch durch Scandium oder Lanthan ersetzt werden.

Bei einer weiteren möglichen Ausführungsform des erfindungsgemäßen Halbleiterbauelements bestehen zumindest alle lichtdurchstrahlten Komponenten der Umhüllung, d. h. auch die Lumineszenzkonversionsschicht aus rein anorganischen Materialien. Das Lumineszenzkonversionselement besteht somit aus einem anorganischen Leuchtstoff, der in einem temperaturstabilen, transparenten oder teiltransparenten anorganischen Material eingebettet ist. Insbesondere besteht das Lumineszenzkonversionselement aus einem anorganischen Phosphor, der in ein vorteilhafterweise niedrig schmelzendes anorganisches Glas (z. B. Silikatglas) eingebettet ist. Eine bevorzugte Herstellungsweise für eine derartige. Lumineszenzkonversionsschicht ist die Sol-Gel-Technik, mit der die gesamte Lumineszenzkonversionsschicht, d. h. sowohl der anorganische Leuchtstoff als auch das Einbettmaterial in einem Arbeitsgang hergestellt werden kann.

Um die Durchmischung der von dem Halbleiterkörper ausgesandten Strahlung des ersten Wellenlängenbereiches mit der lumineszenzkonvertierten Strahlung des zweiten Wellenlängebereiches und damit die Farbhomogenität des abstrahlten Lichtes zu verbessern, ist bei einer vorteilhaften Ausgestaltung des erfindungsgemäßen Halbleiterbauelements der Lumineszenzumhüllung bzw. der Lumineszenzkonversionsschicht und/oder einer anderen Komponente der Bauteilumhüllung zusätzlich ein im Blauen lumineszierender Farbstoff zugefügt, der eine sogenannte Richtcharakteristik der von dem Halbleiterkörper abgestrahlten Strahlung abschwächt. Unter Richtcharakteristik ist zu verstehen, daß die von dem Halbleiterkörper ausgesandte Strahlung eine bevorzugte Abstrahlrichtung aufweist.

Bei einer bevorzugten Ausgestaltung des erfindungsgemäßen Halbleiterbauelements ist zum oben genannten Zweck der Durchmischung der ausgesandten Strahlung der anorganische Leuchtstoff in Pulverform verwendet, wobei sich die Leuchtstoffpartikel in dem sie umhüllenden Stoff (Matrix) nicht lösen. Außerdem weisen der anorganische Leuchtstoff und der ihn umhüllende Stoff voneinander verschiedene Brechungsindizes auf. Dies führt vorteilhafterweise dazu, daß abhängig von der Korngröße des Leuchtstoffes, ein Anteil des nicht vom Leuchtstoff absorbierten Lichtes gestreut wird. Dadurch ist die Richtcharakteristik der von dem Halbleiterkörper abgestrahlten Strahlung effizient geschwächt, so daß die nicht absorbierte Strahlung und die lumineszenzkonvertierte Strahlung homogen gemischt werden, was zu einem räumlich homogenen Farbeindruck führt.

Ein weißes Licht abstrahlendes erfindungsgemäßes Halbleiterbauelement läßt sich besonders bevorzugt dadurch realisieren, daß einem zur Herstellung der Lumineszenzkonversionsschicht verwendeten Epoxidharz der anorganische Leuchtstoff YAG:Ce (Y₃Al₅O₁₂:Ce³⁺) beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffmischung und -konzentration variiert werden.

Der anorganische Leuchtstoff YAG:Ce hat unter anderem den besonderen Vorteil, daß es sich hierbei um nicht lösliche Farbpigmente (Partikelgröße im Bereich von 10 µm) mit einem Brechungsindex von ca. 1,84 handelt. Dadurch tritt neben der Wellenlängenkonversion noch ein Streueffekt auf, der zu einer guten Vermischung von blauer Diodenstrahlung und gelber Konverterstrahlung führt.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements weiter optimieren.

Von besonderem Vorteil ist, daß die Leuchteffizienz von weißleuchtenden erfindungsgemäßen Halbleiterbauelementen bzw. deren o. g. Ausführungsformen mit einem im wesentlichen auf der Basis von GaN hergestellten blau leuchtenden Halbleiterkörper gegenüber der Leuchteffizienz einer Glühbirne erheblich erhöht ist. Der Grund dafür besteht darin, daß zum einen die externe Quantenausbeute derartiger Halbleiterkörper bei einigen Prozent liegt und andererseits die Lumineszenzausbeute von organischen Farbstoff-Molekülen oft bei über 90% angesiedelt ist. Darüberhinaus zeichnet sich das erfindungsgemäße Halbleiterbauelement im Vergleich zur Glühbirne durch eine extrem lange Lebensdauer, größere Robustheit und eine kleinere Betriebsspannung aus.

Vorteilhaft ist weiterhin, daß die für das menschliche Auge wahrnehmbare Helligkeit des erfindungsgemäßen Halbleiterbauelements gegenüber einem ohne Lumineszenzkonversionselement ausgestatteten, aber sonst identischen Halbleiterbauelement deutlich erhöht werden kann, da die Augenempfindlichkeit zu höherer Wellenlänge hin zunimmt.

Darüberhinaus kann mit dem erfindungsgemäßen Prinzip vorteilhafterweise auch eine von dem Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Das hier vorgestellte Konzept der Lumineszenzkonversion mit blauem Licht eines Halbleiterkörpers läßt sich vorteilhafterweise auch auf mehrstufige Lumineszenzkonversionselemente erweitern, nach dem Schema ultraviolett → blau → grün → gelb → rot. Hierbei werden eine Mehrzahl von spektral selektiv emittierenden Lumineszenzkonversionselementen relativ zum Halbleiterkörper hintereinander angeordnet.

Ebenso können vorteilhafterweise mehrere unterschiedlich spektral selektiv emittierende Farbstoffmoleküle gemeinsam in einen transparenten Kunststoff eines Lumineszenzkonversionselements eingebettet sein. Hierdurch ist ein sehr breites Farbenspektrum erzeugbar.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, daß dieser Leuchtstoff bei Anregung mit blauem Licht eine spektrale Verschiebung von ca. 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (z. B. UV-) Stabilität (wesentlich höher als organische Leuchtstoffe), so daß auch Weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt. Denkbar ist jedoch auch die Verwendung von anderen Ce-dotierten Phosphoren, insbesondere Ce-dotierten Granaten.

Besonders vorteilhaft lassen sich erfindungsgemäße Halbleiterbauelemente insbesondere aufgrund ihrer geringen Leistungsaufnahme in vollfarbtauglichen LED-Displays, zur Beleuchtung von Kfz-Innenräumen oder von Flugzeugkabinen sowie zur Beleuchtung von Anzeigevorrichtungen wie Kfz-Armaturen oder Flüssigkristallanzeigen verwenden.

Weitere Merkmale, Vorteile und Zweckmäßigkeiten der Erfindung ergeben sich aus der nachfolgenden Beschreibung von Ausführungsbeispielen in Verbindung mit den Figuren 1 bis 9. Es zeigen:
Figur 1 eine schematische Schnittansicht eines ersten Ausführungsbeispieles eines erfindungsgemäßen Halbleiterbauelements;
Figur 2 eine schematische Schnittansicht eines zweiten Ausführungsbeispieles eines erfindungsgemäßen Halbleiterbauelementes;
Figur 3 eine schematische Schnittansicht durch ein drittes Ausführungsbeispiel eines erfindungsgemäße Halbleiterbauelementes;
Figur 4 eine schematische Schnittansicht eines vierten Ausführungsbeispieles eines erfindungsgemäßen Halbleiterbauelements;
Figur 5 eine schematische Darstellung eines Emissionsspektrums eines blaues Licht abstrahlenden Halbleiterkörpers mit einer Schichtenfolge auf der Basis von GaN;
Figur 6 eine schematische Darstellung der Emissionsspektren zweier erfindungsgemäßer Halbleiterbauelemente, die weißes Licht abstrahlen;
Figur 7 eine schematische Schnittdarstellung durch einen Halbleiterkörper, der blaues Licht aussendet;
Figur 8 eine schematische Darstellung eines Emissionsspektrums eines erfindungsgemäßen Halbleiterbauelementes, das mischfarbiges rotes Licht abstrahlt; und
Figur 9 eine schematische Darstellung der Emissionsspektren von weiteren erfindungsgemäßen Halbleiterbauelementen, die weißes Licht abstrahlen.

In den verschiedenen Figuren sind gleiche bzw. gleichwirkende Teile immer mit denselben Bezugszeichen bezeichnet.

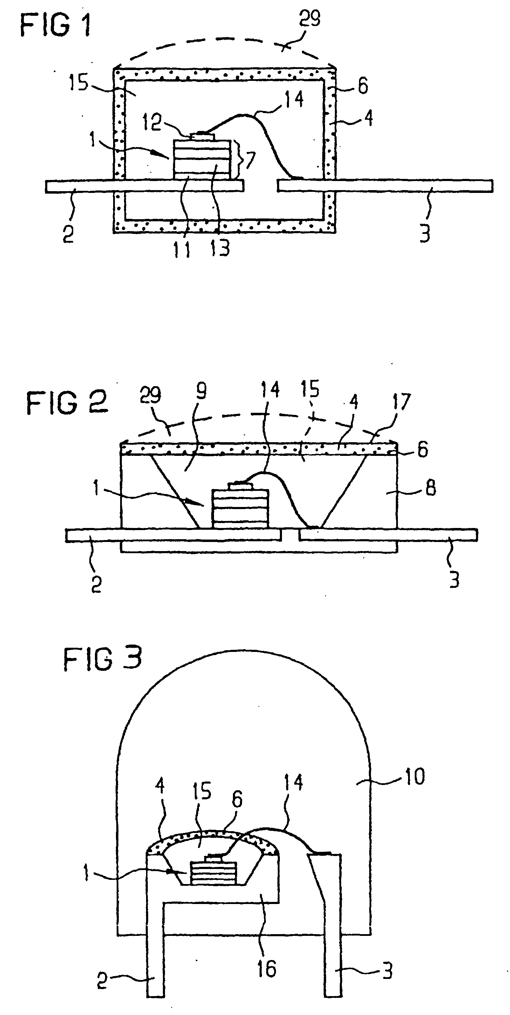

Bei dem in Figur 1 dargestellten Licht aussendenden Halbleiterbauelement weist ein Halbleiterkörper 1 einen Rückseitenkontakt 11, einen Vorderseitenkontakt 12 und eine sich aus einer Anzahl von unterschiedlichen Schichten zusammensetzende Schichtenfolge 7 auf, die im Betrieb des Halbleiterbauelements mindestens eine Strahlung (z. B. ultraviolett, blau oder grün) aussendende aktive Zone besitzt.

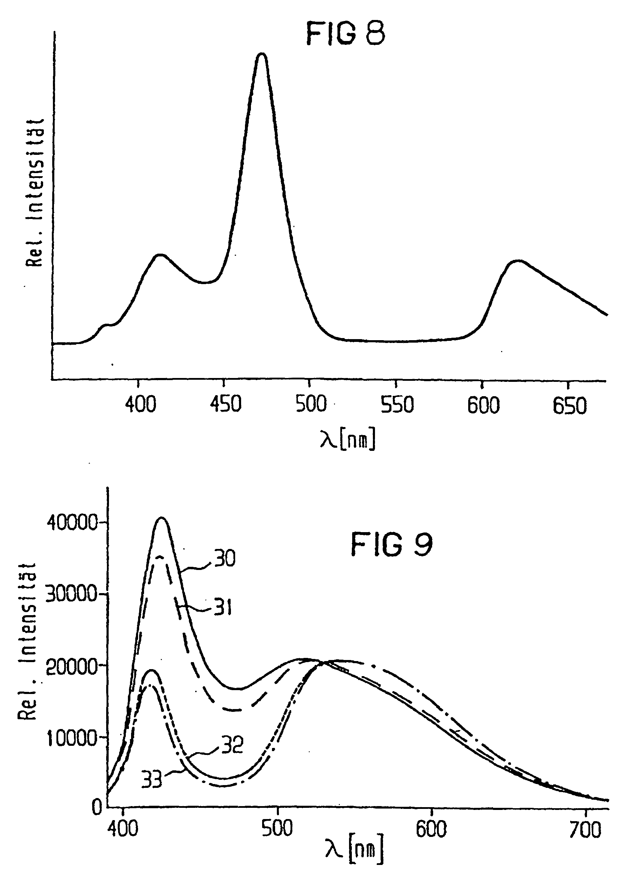

Ein Beispiel für eine geeignete Schichtenfolge 7 für dieses und für sämtliche im folgenden beschriebenen Ausführungsbeispiele ist in Figur 7 gezeigt. Hierbei ist auf einem Substrat 18, das z. B. aus SiC besteht, eine Schichtenfolge aus einer AlN- oder GaN-Schicht 19, einer n-leitenden GaN-Schicht 20, einer n-leitenden GaₓAl₁₋ₓN- oder GaₓIn₁₋ₓN-Schicht 21, einer weiteren n-leitenden GaN- oder einer GaₓIn₁₋ₓN-Schicht 22, einer p-leitenden GaₓAl₁₋ₓN- oder GaₓIn₁₋ₓN-Schicht 23 und einer p-leitenden GaN-Schicht 24 aufgebracht. Auf einer Hauptfläche 25 der p-leitenden GaN-Schicht 24 und einer Hauptfläche 26 des Substrats 18 ist jeweils eine Kontaktmetallisierung 27, 28 aufgebracht, die aus einem herkömmlich in der Opto-Halbleitertechnik für elektrische Kontakte verwendeten Werkstoff besteht.

Es kann jedoch auch jeder andere dem Fachmann für das erfindungsgemäße Halbleiterbauelement als geeignet erscheinende Halbleiterkörper verwendet werden. Dies gilt ebenso für sämtliche nachfolgend beschriebenen Ausführungsbeispiele.

Im Ausführungsbeispiel von Figur 1 ist der Halbleiterkörper 1 mittels eines elektrisch leitenden Verbindungsmittels, z. B. ein metallisches Lot oder ein Klebstoff, mit seinem Rückseitenkontakt 11 auf einem ersten elektrischen Anschluß 2 befestigt. Der Vorderseitenkontakt 12 ist mittels eines Bonddrahtes 14 mit einem zweiten elektrischen Anschluß 3 verbunden.

Der Halbleiterkörper 1 und Teilbereiche der elektrischen Anschlüsse 2 und 3 sind von einer transparenten Umhüllung 15 umschlossen. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie z. B. anorganisches Glas.

Auf diese transparente Umhüllung 15 ist eine Lumineszenzkonversionsschicht 4 aufgebracht, die, wie in der Figur 1 dargestellt, die gesamte Oberfläche der Umhüllung 15 bedeckt. Ebenso denkbar ist, daß die Lumineszenzkonversionsschicht 4 nur einen Teilbereich dieser Oberfläche bedeckt. Die Lumineszenzkonversionsschicht 4 besteht beispielsweise wiederum aus einem transparenten Kunststoff (z. B. Epoxidharz, Lack oder Polymethylmetaacrylat), der mit einem Leuchtstoff 6 versetzt ist. Hier eignet sich als Leuchtstoff für ein weiß leuchtendes Halbleiterbauelement bevorzugt Y₃Al₅O₁₂:Ce³⁺ (YAG:Ce) .

Dieses Ausführungsbeispiel hat den besonderen Vorteil, daß für die gesamte von dem Halbleiterkörper ausgesandte Strahlung die Weglänge durch das Lumineszenzkonverionselement näherungsweise gleich groß ist. Dies spielt insbesondere dann eine bedeutende Rolle, wenn, wie oftmals der Fall, der genaue Farbton des von dem Halbleiterbauelement abgestrahlten Lichtes von dieser Weglänge abhängt.

Zur besseren Auskopplung des Lichtes aus der Lumineszenzkonversionsschicht 4 von Figur 1 kann auf einer Seitenfläche des Bauelements eine linsenförmige Abdeckung 29 (gestrichelt eingezeichnet) vorgesehen sein, die eine Totalreflexion der Strahlung innerhalb der Lumineszenzkonversionsschicht 4 reduziert. Diese linsenförmige Abdeckung 29 kann aus transparentem Kunststoff oder Glas bestehen und auf die Lumineszenzkonversionsschicht 4 beispielsweise aufgeklebt oder direkt als Bestandteil der Lumineszenzkonversionsschicht 4 ausgebildet sein.

Bei dem in Figur 2 dargestellten Ausführungsbeispiel sind der erste und zweite elektrische Anschluß 2,3 in ein lichtundurchlässiges evtl. vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzguß fertig ausgebildet ist, bevor der Halbleiterkörper auf den Anschluß 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist von einer Lumineszenzkonversionsschicht 4, beispielsweise eine separat hergestellte und auf dem Grundgehäuse 8 befestigte Abdeckplatte 17 aus Kunststoff abgedeckt.

Als geeignete Materialien für die Lumineszenzkonversionsschicht 4 kommen wiederum die weiter oben im allgemeinen Teil der Beschreibung genannten Kunststoffe oder anorganisches Glas in Verbindung mit den dort genannten Leuchtstoffen in Frage. Die Ausnehmung 9 kann sowohl mit einem transparenten Kunststoff, mit einem anorganischen Glas oder mit Gas gefüllt als auch mit einem Vakuum versehen sein.

Wie bei dem Ausführungsbeispiel nach Figur 1 kann auch hier zur besseren Auskopplung des Lichtes aus der Lumineszenzkonversionsschicht 4 auf dieser eine linsenförmige Abdeckung 29 (gestrichelt eingezeichnet) vorgesehen sein, die eine Totalreflexion der Strahlung innerhalb der Lumineszenzkonversionsschicht 4 reduziert. Diese Abdeckung 29 kann aus transparentem Kunststoff bestehen und auf die Lumineszenzkonversionsschicht 4 beispielsweise aufgeklebt oder zusammen mit der Lumineszenzkonversionsschicht 4 einstückig ausgebildet sein.

In Figur 3 ist als weiteres Ausführungsbeispiel eine sogenannte Radialdiode dargestellt. Hierbei ist der Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Bei dem Ausführungsbeispiel von Figur 3 ist der Halbleiterkörper 1 von einer transparenten Umhüllung 15 umgeben, die, wie beim erstgenannten Ausführungsbeispiel (Figur 1), keine Wellenlängenänderung der von dem Halbleiterkörper 1 ausgesandten Strahlung bewirkt und beispielsweise aus einem herkömmlich in der Leuchtdiodentechnik verwendeten transparenten Epoxidharz oder aus organischem Glas bestehen kann.

Auf dieser transparenten Umhüllung 15 ist eine Lumineszenzkonversionsschicht 4 aufgebracht. Als Material hierfür kommen beispielsweise wiederum die im Zusammenhang mit den vorgenannten Ausführungsbeispielen angeführten Kunststoffe oder anorganisches Glas in Verbindung mit den dort genannten Farbstoffen in Frage.

Der gesamte Aufbau, bestehend aus Halbleiterkörper 1, Teilbereiche der elektrischen Anschlüsse 2,3, transparente Umhüllung 15 und Lumineszenzkonversionsschicht 4, ist unmittelbar von einer weiteren transparenten Umhüllung 10 umschlossen, die keine Wellenlängenänderung der durch die Lumineszenzkonversionsschicht 4 hindurchgetretenen Strahlung bewirkt. Sie besteht beispielsweise wiederum aus einem herkömmlich in der Leuchtdiodentechnik verwendeten transparenten Epoxidharz oder aus anorganischem Glas.

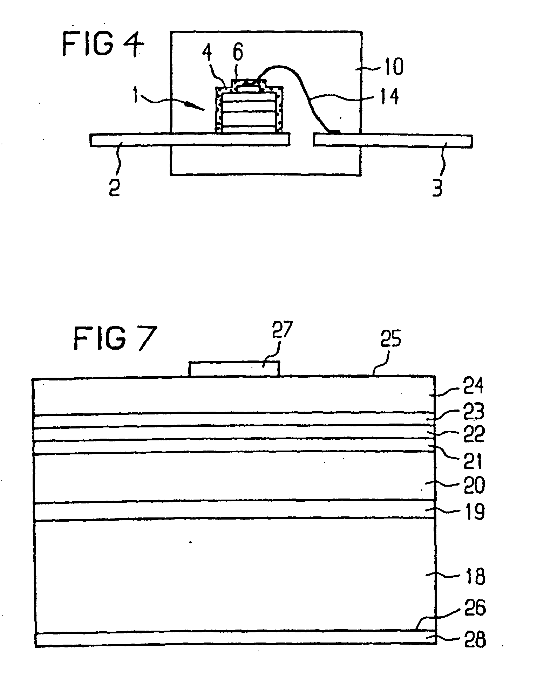

Bei dem Ausführungsbeispiel von Figur 4 ist eine Lumineszenzkonversionsschicht 4 (mögliche Materialien wie oben angegeben) direkt auf den Halbleiterkörper 1 aufgebracht. Dieser und Teilbereiche der elektrischen Anschlüsse 2,3 sind von einer weiteren transparenten Umhüllung 10 umschlossen, die keine Wellenlängenänderung der durch die Lumineszenzkonversionsschicht 4 hindurchgetretenen Strahlung bewirkt und beispielsweise aus einem in der Leuchtdiodentechnik verwendbaren transparenten Epoxidharz oder aus Glas gefertigt ist.

Solche, mit einer Lumineszenzkonversionsschicht 4 versehenen Halbleiterkörper 1 ohne Umhüllung können natürlich vorteilhafterweise in sämtlichen aus der Leuchtdiodentechnik bekannten Gehäusebauformen (z. B. SMD-Gehäuse, Radial-Gehäuse (man vergleiche Figur 4)) verwendet sein.

Bei sämtlichen der oben beschriebenen Ausführungsbeispiele kann zur Optimierung des Farbeindrucks des abstrahlten Lichts sowie zur Anpassung der Abstrahlcharakteristik das Lumineszenzkonversionselement (Lumineszenzkonversionsschicht 4), ggf. die transparente Umhüllung 15, und/oder ggf. die weitere transparente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂ SiO₂ Ca-CO₃ oder BaSO₄ oder auch organische Pigmente. Diese Materialien können auf einfache Weise den o. g. Kunststoffen zugesetzt werden.

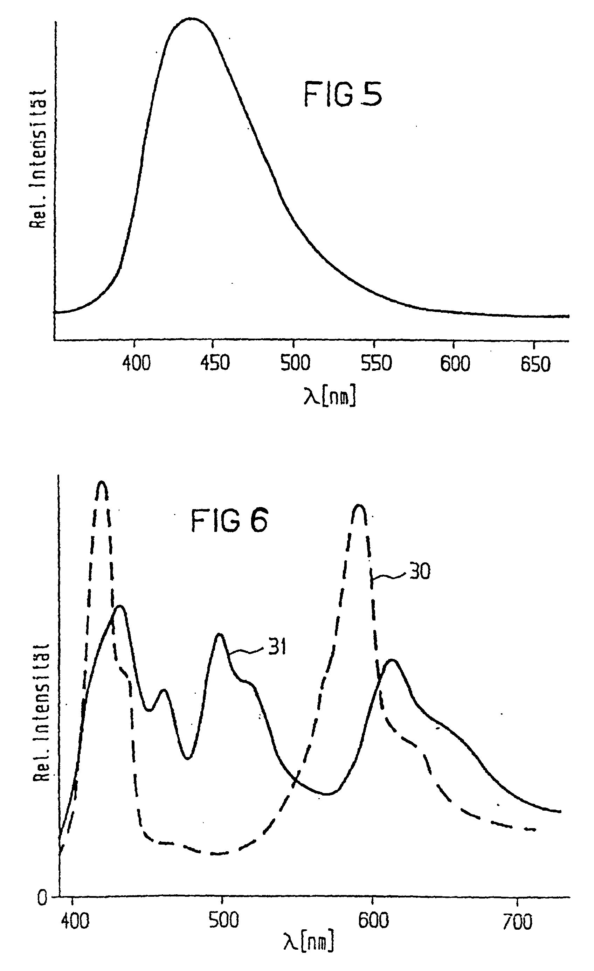

In den Figuren 5, 6 und 9 sind Emissionsspektren eines blaues Licht abstrahlenden Halbleiterkörpers (Fig. 5) (Lumineszenzmaximum bei λ ~ 430 nm) bzw. von mittels eines solchen Halbleiterkörpers hergestellten Weiß leuchtenden erfindungsgemäßen Halbleiterbauelementen (Fig. 6 und 9) gezeigt. An der Abszisse ist jeweils die Wellenänge λ in nm und auf der Ordinate ist jeweils eine relative Elektrolumineszenz(EL)-Intensität aufgetragen.

Von der vom Halbeiterkörper ausgesandten Strahlung nach Figur 5 wird nur ein Teil in einen längerwelligen Wellenlängenbereich konvertiert, so daß als Mischfarbe weißes Licht entsteht. Die gestrichelte Linie 30 in Figur 6 stellt ein Emissionsspektrum von einem erfindungsgemäßen Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen ca. 400 und ca. 430 nm (Blau) und zwischen ca. 550 und ca. 580 nm (Gelb) je ein Maximum auf. Die durchgezogene Linie 31 repräsentiert das Emissionsspektrum eines erfindungsgemäßen Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von ca. 430 nm (Blau), ca. 500 nm (Grün) und ca. 615 nm (Rot) je ein Maximum auf.

Desweiteren ist in Figur 8 ein Emissionsspektrum eines erfindungsgemäßen Halbleiterbauelements dargestellt, das mischfarbiges Licht aus blauem Licht (Maximum bei einer Wellenlänge von ca. 470 nm) und rotem Licht (Maximum bei einer Wellenlänge von ca. 620 nm) abstrahlt. Der Gesamtfarbeindruck des abgestrahlten Lichtes für das menschliche Auge ist Magenta. Das vom Halbleiterkörper abgestrahlte Emissionsspektrum entspricht hier wiederum dem von Figur 5.

Figur 9 zeigt ein Weiß leuchtendes erfindungsgemäßes Halbleiterbauelement, das mit einem ein Emissions-Spektrum gemäß Figur 5 aussendenden Halbleiterkörper versehen ist und bei dem als Leuchtstoff YAG:Ce verwendet ist. Von der vom Halbeiterkörper ausgesandten Strahlung nach Figur 5 wird nur ein Teil in einen längerwelligen Wellenlängenbereich konvertiert, so daß als Mischfarbe weißes Licht entsteht. Die verschiedenartig gestrichelten Linien 30 bis 33 von Figur 9 stellen Emissionsspektren von erfindungsgemäßen Halbleiterbauelementen dar, bei denen das Lumineszenzkonversionselement, in diesem Fall eine Lumineszenzkonversionsumhüllung aus Epoxidharz, unterschiedliche YAG:Ce-Konzentrationen aufweist. Jedes Emissionsspektrum weist zwischen λ = 420 nm und λ = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 9 verdeutlicht, daß bei dem erfindungsgemäßen Halbleiterbauelement auf einfache Weise durch Veränderung der Leuchtstoffkonzentration im Epoxidharz der CIE-Farbort des weißen Lichtes verändert werden kann.

Weiterhin ist es möglich, anorganische Leuchtstoffe auf Basis von Ce-dotierten Granaten, Thiogallaten, Erdalkali-Sulfiden und Aluminaten direkt auf den Halbleiterkörper aufzubringen, ohne sie in Epoxidharz oder Glas zu dispergieren.

Ein weiterer besonderer Vorteil der oben genannten anorganischen Leuchtstoffe ergibt sich daraus, daß die Leuchtstoffkonzentration z.B. im Epoxidharz nicht wie bei organischen Farbstoffen durch die Löslichkeit begrenzt wird. Dadurch sind keine großen Dicken von Lumineszenzkonversionselementen nötig.

Die Erläuterung des erfindungsgemäßen Halbleiterbauelements anhand der oben beschriebenen Ausführungsbeispiele ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Lichtabstrahlendes Halbleiterbauelement mit einem Halbleiterkörper (1), der im Betrieb des Halbleiterbauelements elektromagnetische Strahlung aussendet, mit mindestens einem ersten und mindestens einem zweiten elektrischen Anschluß (2, 3), die mit dem Halbleiterkörper (1) elektrisch leitend verbunden sind, und mit einem Lumineszenzkonversionselement, das mindestens einen Leuchtstoff aufweist, bei dem
der Halbleiterkörper (1) eine Halbleiterschichtenfolge (7) aufweist, die geeignet ist, im Betrieb des Halbleiterbauelements elektromagnetische Strahlung eines ersten Wellenlängenbereiches aus dem ultravioletten, blauen und/oder grünen Spektralbereich auszusenden,
das Lumineszenzkonversionselement eine aus dem ersten Wellenlängenbereich stammende Strahlung in Strahlung eines vom ersten verschiedenen zweiten Wellenlängenbereiches umwandelt, derart, daß das Halbleiterbauelement Mischstrahlung, bestehend aus Strahlung des ersten Wellenlängenbereiches und Strahlung des zweiten Wellenlängenbereiches aussendet, und
als Lumineszenzkonversionselement über oder auf dem Halbleiterkörper (1) eine Lumineszenzkonversionsschicht (4) vorgesehen ist, **dadurch gekennzeichnet, daß** die Lumineszenzkonversionsschicht (4) durchweg eine konstante Dicke aufweist.

2. Lichtabstrahlendes Halbleiterbauelement nach Anspruch 1, bei dem das Lumineszenzkonversionselement Strahlung des ersten Wellenlängenbereichs in Strahlung mehrerer zweiter Wellenlängenbereiche aus voneinander verschiedenen spektralen Teilbereichen umwandelt, derart, daß das Halbleiterbauelement Mischstrahlung, bestehend aus Strahlung des ersten Wellenlängenbereiches und Strahlung der zweiten Wellenlängenbereiche aussendet.

3. Lichtabstrahlendes Halbleiterbauelement nach Anspruch 1 oder 2, bei dem die Lumineszenzkonversionsschicht direkt auf den Halbleiterkörper aufgebracht ist.

4. Lichtabstrahlendes Halbleiterbauelement nach einem der Ansprüche 1 bis 3, bei dem der bzw. die zweiten Wellenlängenbereiche zumindest teilweise größere Wellenlängen λ aufweisen, als der erste Wellenlängenbereich.

5. Lichtabstrahlendes Halbleiterbauelement nach einem der-Ansprüche 1 bis 4, bei dem der Halbleiterkörper (1) im Betrieb des Halbleiterbauelements ultraviolette Strahlung aussendet und daß das Lumineszenzkonversionselement zumindest einen Teil dieser ultravioletten Strahlung in sichtbares Licht umwandelt.

6. Lichtabstrahlendes Halbleiterbauelement nach einem der Ansprüche 1 bis 5, bei dem der erste Wellenlängenbereich und der zweite Wellenlängenbereich der Mischstrahlung zumindest teilweise in zueinander komplementärfarbigen Spektralbereichen liegen, so daß weißes Licht erzeugt wird.

7. Lichtabstrahlendes Halbleiterbauelement nach Anspruch 2 oder nach Anspruch 2 in Verbindung mit einem der Ansprüche 3 bis 5, **dadurch gekennzeichnet, daß** der vom Halbleiterkörper ausgesandte erste Wellenlängenbereich und zwei zweite Wellenlängenbereiche ein additives Farbtripel ergeben, derart, daß in Betrieb des Halbleiterbauelements von diesem weißes Licht abgestrahlt wird.

8. Lichtabstrahlendes Halbleiterbauelement nach einem der Ansprüche 1 bis 7, bei dem die vom Halbleiterkörper (1) ausgesandte Strahlung im blauen Spektralbereich bei einer Wellenlänge λ zwischen 420 nm und 460 nm ein Lumineszenz-Intensitätsmaximum aufweist.

9. Lichtabstrahlendes Halbleiterbauelement nach einem der Ansprüche 1 bis 8, bei dem der Halbleiterkörper (1) in einer Ausnehmung (9) eines lichtundurchlässigen Grundgehäuses (8) angeordnet ist und daß die Ausnehmung (9) mit einer eine Lumineszenzkonversionsschicht (4) aufweisenden Abdeckschicht versehen ist.

10. Lichtabstrahlendes Halbleiterbauelement nach einem der Ansprüche 1 bis 9, **dadurch gekennzeichnet, daß** der Halbleiterkörper (1) in einer Ausnehmung (9) eines lichtundurchlässigen Grundgehäuses (8) angeordnet ist und daß die Ausnehmung (9) zumindest teilweise von dem Lumineszenzkonversionselement ausgefüllt ist.

11. Lichtabstrahlendes Halbleiterbauelement nach einem der Ansprüche 1 bis 10, bei dem das Lumineszenzkonversionselement mehrere Schichten mit unterschiedlichen Wellenlängenkonversionseigenschaften aufweist.

12. Lichtabstrahlendes Halbleiterbauelement nach einem der Ansprüche 1 bis 11, bei dem das Lumineszenzkonversionselement organische Farbstoffmoleküle in einer Kunststoff-Matrix aufweist, die insbesondere aus Silikon-, Thermoplast- oder Duroplastmaterial besteht.

13. Lichtabstrahlendes Halbleiterbauelement nach Anspruch 12, bei dem das Lumineszenzkonversionselement organische Farbstoffmoleküle in einer Epoxidharz-Matrix aufweist.

14. Lichtabstrahlendes Halbleiterbauelement nach Anspruch 12, bei dem das Lumineszenzkonversionselement organische Farbstoffmoleküle in einer Polymethyletacrylat-Matrix aufweist.

15. Lichtabstrahlendes Halbleiterbauelement nach einem der Ansprüche 1 bis 11, bei dem das Lumineszenzkonversionselement (4, 5) mindestens einen anorganischen Leuchtstoff (6) aus der Gruppe der Phosphore aufweist.

16. Lichtabstrahlendes Halbleiterbauelement nach Anspruch 15, bei dem der anorganische Leuchtstoff aus der Gruppe der Ce-dotierten Granate ist.

17. Lichtabstrahlendes Halbleiterbauelement nach Anspruch 16, bei dem der anorganische Leuchtstoff YAG:Ce ist.

18. Lichtabstrahlendes Halbleiterbauelement nach einem der Ansprüche 15 bis 17, bei dem der anorganische Leuchtstoff in einer Epoxidharz-Matrix eingebettet ist.

19. Lichtabstrahlendes Halbleiterbauelement nach einem der Ansprüche 15 bis 17, bei dem der anorganische Leuchtstoff in einer Matrix aus einem niedrigschmelzenden anorganischen Glas eingebettet ist.

20. Lichtabstrahlendes Halbleiterbauelement nach Anspruch 18-oder 19, bei dem der anorganische Leuchtstoff eine mittlere Partikelgröße von ca. 10 µm aufweist.

21. Lichtabstrahlendes Halbleiterbauelement nach einem der Ansprüche 1 bis 20, **dadurch gekennzeichnet, daß** das Lumineszenzkonversionselement mit mehreren verschiedenen organischen und/oder anorganischen Leuchtstoffen (6) versehen ist.

22. Lichtabstrahlendes Halbleiterbauelement nach einem der Ansprüche 1 bis 21, bei dem das Lumineszenzkonversionselement organische und/oder anorganische Farbstoffmoleküle mit und ohne Wellenlängenkonversionswirkung aufweist.

23. Lichtabstrahlendes Halbleiterbauelement nach einem der Ansprüche 1 bis 22, bei dem das Lumineszenzkonversionselement und/oder eine transparente Umhüllung (10, 15) lichtstreuende Partikel aufweist.

24. Lichtabstrahlendes Halbleiterbauelement nach einem der Ansprüche 1 bis 23, bei dem das Lumineszenzkonversionselement und/oder eine transparente Umhüllung (10, 15) mit mindestens einem im Blauen lumineszierenden Leuchtstoff versehen ist.

25. Verwendung einer Mehrzahl von lichtabstrahlenden Halbleiterbauelementen gemäß einem der Ansprüche 1 bis 24 in einer vollfarbtauglichen LED-Anzeigevorrichtung.

26. Verwendung einer Mehrzahl von lichtabstrahlenden Halbleiterbauelementen gemäß einem der Ansprüche 1 bis 24 zur Innenraumbeleuchtung von Flugzeugkabinen.

27. Verwendung eines lichtabstrahlenden Halbleiterbauelements gemäß einem der Ansprüche 1 bis 25 zur Beleuchtung von Anzeigevorrichtungen, insbesondere zur Beleuchtung von Flüssigkristallanzeigen.

## Claims

1. Light emitting semiconductor component having a semiconductor body (1), which emits electromagnetic radiation during operation of the semiconductor component, having at least one first and at least one second electrical connection (2, 3), which are electrically conductively connected to the semiconductor body (1), and having a luminescence conversion element, which has at least one luminescent material, in which
the semiconductor body (1) has a semiconductor layer sequence (7), which is suitable for emitting electromagnetic radiation of a first wavelength range from the ultraviolet, blue and/or green spectral region during operation of the semiconductor component,
the luminescence conversion element converts a radiation originating from the first wavelength range into radiation of a second wavelength range, which differs from the first wavelength range, in such a way that the semiconductor component emits mixed radiation, comprising radiation of the first wavelength range and radiation of the second wavelength range, and
a luminescence conversion layer (4) is provided as the luminescence conversion element above or on the semiconductor body (1), **characterized in that** the luminescence conversion layer (4) has a constant thickness throughout.

2. Light emitting semiconductor component according to Claim 1, in which the luminescence conversion element converts radiation of the first wavelength range into radiation of a plurality of second wavelength ranges from mutually different spectral subregions, in such a way that the semiconductor component emits mixed radiation, comprising radiation of the first wavelength range and radiation of the second wavelength ranges.

3. Light emitting semiconductor component according to Claim 1 or 2, in which the luminescence conversion layer is applied directly to the semiconductor body.

4. Light emitting semiconductor component according to one of Claims 1 to 3, in which the second wavelength range or ranges has or have wavelengths λ at least some of which are greater than those of the first wavelength range.

5. Light emitting semiconductor component according to one of Claims 1 to 4, in which the semiconductor body (1) emits ultraviolet radiation during operation of the semiconductor component, and in that the luminescence conversion element converts at least part of this ultraviolet radiation into visible light.

6. Light emitting semiconductor component according to one of Claims 1 to 5, in which the first wavelength range and the second wavelength range of the mixed radiation lie at least partially in mutually complementarily coloured spectral regions, with the result that white light is produced.

7. Light emitting semiconductor component according to Claim 2 or according to Claim 2 in conjunction with one of Claims 3 to 5, **characterized in that** the first wavelength range emitted by the semiconductor body and two second wavelength ranges produce an additive colour triad, in such a way that white light is emitted by the semiconductor component during operation thereof.

8. Light emitting semiconductor component according to one of Claims 1 to 7, in which the radiation emitted by the semiconductor body (1) has a luminescence intensity maximum in the blue spectral region at a wavelength λ of between 420 nm and 460 nm.

9. Light emitting semiconductor component according to one of Claims 1 to 8, in which the semiconductor body (1) is arranged in a recess (9) of an opaque base housing (8), and in that the recess (9) is provided with a covering layer having a luminescence conversion layer (4).

10. Light emitting semiconductor component according to one of Claims 1 to 9, **characterized in that** the semiconductor body (1) is arranged in a recess (9) of an opaque base housing (8), and **in that** the recess (9) is at least partially filled by the luminescence conversion element.

11. Light emitting semiconductor component according to one of Claims 1 to 10, in which the luminescence conversion element has a plurality of layers having different wavelength conversion properties.

12. Light emitting semiconductor component according to one of Claims 1 to 11, in which the luminescence conversion element has organic dye molecules in a plastic matrix, which is composed, in particular, of silicon, thermoplastic or thermosetting plastic material.

13. Light emitting semiconductor component according to Claim 12, in which the luminescence conversion element has organic dye molecules in an epoxy resin matrix.

14. Light emitting semiconductor component according to Claim 12, in which the luminescence conversion element has organic dye molecules in a polymethyl methacrylate matrix.

15. Light emitting semiconductor component according to one of Claims 1 to 11, in which the luminescence conversion element (4, 5) has at least one inorganic luminescent material (6) from the group of phosphors.

16. Light emitting semiconductor component according to Claim 15, in which the inorganic luminescent material is from the group of Ce-doped garnets.

17. Light emitting semiconductor component according to Claim 16, in which the inorganic luminescent material is YAG:Ce.

18. Light emitting semiconductor component according to one of Claims 15 to 17, in which the inorganic luminescent material is embedded in an epoxy resin matrix.

19. Light emitting semiconductor component according to one of Claims 15 to 17, in which the inorganic luminescent material is embedded in a matrix made of an inorganic glass of low melting point.

20. Light emitting semiconductor component according to Claim 18 or 19, in which the inorganic luminescent material has an average particle size of approximately 10 µm.

21. Light emitting semiconductor component according to one of Claims 1 to 20, **characterized in that** the luminescence conversion element is provided with a plurality of different organic and/or inorganic luminescent materials (6).

22. Light emitting semiconductor component according to one of Claims 1 to 21, in which the luminescence conversion element has organic and/or inorganic dye molecules with and without a wavelength conversion effect.

23. Light emitting semiconductor component according to one of Claims 1 to 22, in which the luminescence conversion element and/or a transparent encapsulation (10, 15) have/has light-diffusing particles.

24. Light emitting semiconductor component according to one of Claims 1 to 23, in which the luminescence conversion element and/or a transparent encapsulation (10, 15) are/is provided with at least one luminescent material which is luminescent in the blue region.

25. Use of a plurality of light emitting semiconductor components according to one of Claims 1 to 24 in a full-colour LED display device.

26. Use of a plurality of light emitting semiconductor components according to one of Claims 1 to 24 for the interior lighting of aircraft cabins.

27. Use of a light emitting semiconductor component according to one of Claims 1 to 25 for the illumination of display devices, in particular for the illumination of liquid crystal displays.

## Revendications

1. Composant à semi-conducteur émettant de la lumière, comportant un corps semi-conducteur (1), qui lors de l'utilisation du composant à semi-conducteur émet un rayonnement électromagnétique, comportant au moins une première et au moins une deuxième bornes électriques (2, 3), qui sont reliées d'une manière conductrice de l'électricité avec le corps semi-conducteur (1), et comportant un élément de conversion de luminescence, qui a au moins une substance luminescente,
dans lequel le corps semi-conducteur (1) comporte une séquence (7) de couches semi-conductrices, qui, lors de l'utilisation du composant à semi-conducteur, est à même d'émettre un rayonnement électromagnétique correspondant à un premier domaine de longueurs d'onde, choisi parmi le domaine spectral ultraviolet, bleu et/ou vert,
l'élément de conversion de luminescence convertit un rayonnement provenant du premier domaine de longueurs d'onde en un rayonnement dans un deuxième domaine de longueurs d'onde, différent du premier, de telle sorte que le composant à semi-conducteur émet un rayonnement mixte, constitué d'un rayonnement correspondant au premier domaine de longueurs d'onde et d'un rayonnement correspondant au deuxième domaine de longueurs d'onde, et
il est prévu, en tant qu'élément de conversion de luminescence, au-dessus du corps semi-conducteur (1) ou sur ce dernier, une couche de conversion de luminescence (4),
**caractérisé en ce que** la couche de conversion de luminescence (4) a partout une épaisseur constante.

2. Composant à semi-conducteur émettant de la lumière selon la revendication 1, dans lequel l'élément de conversion de luminescence convertit un rayonnement correspondant au premier domaine de longueurs d'onde en un rayonnement correspondant à plusieurs deuxièmes domaines de longueurs d'onde, constitués de domaines spectraux partiels différents les uns des autres, de telle sorte que le composant à semi-conducteur émet un rayonnement mixte, constitué d'un rayonnement correspondant au premier domaine de longueurs d'onde et d'un rayonnement correspondant aux deuxièmes domaines de longueurs d'onde.

3. Composant à semi-conducteur émettant de la lumière selon la revendication 1 ou 2, dans lequel la couche de conversion de luminescence est directement appliquée sur le corps semi-conducteur.

4. Composant à semi-conducteur émettant de la lumière selon l'une des revendications 1 à 3, dans lequel le ou les deuxièmes domaines de longueurs d'onde comportent au moins partiellement des longueurs d'onde λ plus grandes que le premier domaine de longueurs d'onde.

5. Composant à semi-conducteur émettant de la lumière selon l'une des revendications 1 à 4, dans lequel le corps semi-conducteur (1), lors de l'utilisation du composant semi-conducteur, émet un rayonnement ultraviolet, et en ce que l'élément de conversion de luminescence convertit au moins une partie de ce rayonnement ultraviolet en une lumière visible.

6. Composant à semi-conducteur émettant de la lumière selon l'une des revendications 1 à 5, dans lequel le premier domaine de longueurs d'onde et le deuxième domaine de longueurs d'onde du rayonnement mixte se trouvent au moins en partie dans des domaines spectraux présentant entre eux des couleurs complémentaires, de telle sorte qu'il y ait production d'une lumière blanche.

7. Composant à semi-conducteur émettant de la lumière selon la revendication 2, ou selon la revendication 2 en liaison avec l'une des revendications 3 à 5, **caractérisé en ce que** le premier domaine de longueurs d'onde émis par le corps semi-conducteur et deux deuxièmes domaines de longueurs d'onde donnent une triade de couleurs additives, de telle sorte que, en cours d'utilisation du composant semi-conducteur, une lumière blanche soit émise par ce dernier par luminescence.

8. Composant à semi-conducteur émettant de la lumière selon l'une des revendications 1 à 7, dans lequel le rayonnement émis par le corps semi-conducteur (1) comporte un maximum d'intensité de luminescence dans le domaine spectral bleu, à une longueur d'onde λ comprise entre 420 et 460 nm.

9. Composant à semi-conducteur émettant de la lumière selon l'une des revendications 1 à 8, dans lequel le corps semi-conducteur (1) est disposé dans un évidement (9) aménagé dans un boîtier de base (8), imperméable à la lumière, et en ce que l'évidement (9) est pourvu d'une couche de recouvrement comportant une couche de conversion de luminescence (4).

10. Composant à semi-conducteur émettant de la lumière selon l'une des revendications 1 à 9, **caractérisé en ce que** le corps semi-conducteur (1) est disposé dans un évidement (9) aménagé dans un boîtier de base (8) imperméable à la lumière, et **en ce que** l'évidement (9) est au moins en partie rempli par l'élément de conversion de luminescence.

11. Composant à semi-conducteur émettant de la lumière selon l'une des revendications 1 à 10, dans lequel l'élément de conversion de luminescence comporte plusieurs couches ayant des propriétés différentes de conversion de longueurs d'onde.

12. Composant à semi-conducteur émettant de la lumière selon l'une des revendications 1 à 11, dans lequel l'élément de conversion de luminescence comprend des molécules de colorants organiques dans une matrice en une matière plastique, qui en particulier est constitué d'une matière de silicone, thermoplastique ou thermodurcissable.

13. Composant à semi-conducteur émettant de la lumière selon la revendication 12, dans lequel l'élément de conversion de luminescence comprend des molécules de colorants organiques dans une matrice constituée d'une résine époxyde.

14. Composant à semi-conducteur émettant de la lumière selon la revendication 12, dans lequel l'élément de conversion de luminescence comprend des molécules de colorants organiques dans une matrice constituée de poly(méthacrylate de méthyle).

15. Composant à semi-conducteur émettant de la lumière selon l'une des revendications 1 à 11, dans lequel l'élément de conversion de luminescence (4, 5) comprend au moins une substance luminescente minérale (6), choisie dans le groupe des substances fluorescentes.

16. Composant à semi-conducteur émettant de la lumière selon la revendication 15, dans lequel la substance luminescente minérale entre dans le groupe des grenats dopés au Ce.

17. Composant à semi-conducteur émettant de la lumière selon la revendication 16, dans lequel la substance luminescente minérale est du YAG:Ce.

18. Composant à semi-conducteur émettant de la lumière selon l'une des revendications 15 à 17, dans lequel la substance luminescente minérale est incorporée à une matrice d'une résine époxyde.

19. Composant à semi-conducteur émettant de la lumière selon l'une des revendications 15 à 17, dans lequel la substance luminescente minérale est incorporée à une matrice constituée d'un verre minéral à bas point de fusion.

20. Composant à semi-conducteur émettant de la lumière selon la revendication 18 ou 19, dans lequel la substance luminescente minérale a une granulométrie moyenne d'environ 10 µm.

21. Composant à semi-conducteur émettant de la lumière selon l'une des revendications 1 à 20, **caractérisé en ce que** l'élément de conversion de luminescence est pourvu de plusieurs substances luminescentes organiques et/ou minérales différentes (6).

22. Composant à semi-conducteur émettant de la lumière selon l'une des revendications 1 à 21, dans lequel l'élément de conversion de luminescence comprend des molécules d'un colorant organique et/ou minérale, avec et sans effet de conversion de longueurs d'onde.

23. Composant à semi-conducteur émettant de la lumière selon l'une des revendications 1 à 22, dans lequel l'élément de conversion de luminescence et/ou une enveloppe transparente (10, 15) comprennent des particules de dispersion de la lumière.

24. Composant à semi-conducteur émettant de la lumière selon l'une des revendications 1 à 23, dans lequel l'élément de conversion de luminescence et/ou une enveloppe transparente (10, 15) sont pourvu d'au moins une substance luminescente dans le bleu.

25. Utilisation d'un grand nombre de composants à semi-conducteurs émettant de la lumière selon l'une des revendications 1 à 24 dans un dispositif d'affichage à diodes électroluminescentes convenant à des couleurs pleines.

26. Utilisation d'un grand nombre de composants à semi-conducteurs émettant de la lumière selon l'une des revendications 1 à 24, pour l'éclairage intérieur de cabines d'avion.

27. Utilisation d'un composant à semi-conducteur émettant de la lumière selon l'une des revendications 1 à 25 pour éclairer des dispositifs d'affichage, en particulier pour éclairer des affichages à cristaux liquides.
